# FASCICULE DE BREVET EUROPEEN

(11) **EP 3 100 465 B1**
(45) Date de publication et mention de la délivrance du brevet: **03.10.2018**
(21) Numéro de dépôt: 15705632.6
(22) Date de dépôt: 15.01.2015
(51) Int. Cl.: H04Q 9/00, G01R 31/36, H01M 10/42

(54) **SYSTÈME ET PROCÉDÉ CORRESPONDANT DE GESTION D'UNE BATTERIE COMPRENANT UNE PLURALITÉ DE CELLULES DE BATTERIE**
SYSTEM UND ENTSPRECHENDES VERFAHREN ZUR VERWALTUNG EINER BATTERIE MIT MEHREREN BATTERIEZELLEN
SYSTEM AND CORRESPONDING METHOD FOR MANAGING A BATTERY COMPRISING A PLURALITY OF BATTERY CELLS

(30) Priorité: 30.01.2014 FR 1450728
(43) Date de publication de la demande: 07.12.2016
(73) Titulaire: Renault S.A.S., 92100 Boulogne-Billancourt (FR)
(72) Inventeur: BACQUET, Sylvain, F-38470 Chasselay (FR); LEIRENS, Sylvain, F-38000 Grenoble (FR); MENSLER, Michel, F-78180 Montigny Le Bretonneux (FR); PALMIERI, Michael, F-38000 Grenoble (FR)
(74) Mandataire: GIE Innovation Competence Group
(86) Numéro de dépôt international: PCT/FR2015/050093
(87) Numéro de publication internationale: WO 2015/114234

(56) Documents cités:
- EP-A2- 1 933 443
- WO-A1-2012/171919
- US-A1- 2013 130 068

## Description

L'invention concerne les batteries formées par l'assemblage en série d'une pluralité de cellules, la gestion de ces batteries, et en particulier la communication d'informations relatives aux tensions aux bornes des cellules.

De telles batteries peuvent être utilisées dans les véhicules automobiles à traction électrique ou hybride, ou dans d'autres types de systèmes qui embarquent une batterie.

En général, pour ces applications, des batteries de très forte capacité sont utilisées, capables de délivrer plusieurs dizaines d'ampères-heures, avec une tension à leurs bornes très élevée, par exemple de l'ordre de 400 volts. Pour obtenir des valeurs de tension aussi élevées, on assemble en série des cellules ayant chacune une tension de l'ordre de quelques volts. Ces cellules peuvent constituer un module (de taille variable) ou la totalité de la batterie.

De manière classique, on surveille les cellules pour s'assurer que la tension aux bornes de ces cellules soit située dans la plage de tension nominale du module ou de la batterie. En effet, il convient de vérifier que la tension aux bornes d'une cellule n'est pas trop basse pour éviter les détériorations de la cellule, et il convient également de vérifier que la tension aux bornes d'une cellule n'est pas trop haute pour éviter à la fois les détériorations de la cellule et également les inflammation et explosions de la cellule.

On utilise alors des moyens de mesure de la tension aux bornes des cellules formant une batterie. Ces moyens de mesure sont alimentés directement par la cellule pour laquelle ils mesurent la ou les tensions. La valeur de tension mesurée est ensuite communiquée à une unité centrale, ou unité de commande électronique, qui peut également envoyer des commandes à des moyens destinés à l'équilibrage d'une cellule. De ce fait, on utilise au moins deux connexions distinctes entre chaque cellule et l'unité centrale.

Comme on le conçoit, puisque les moyens de tensions sont alimentés directement par les cellules ou les modules, et que l'unité centrale est alimentée par d'autres sources d'énergie électrique, il est nécessaire d'utiliser des moyens d'isolation dans chaque connexion entre la cellule ou le module et l'unité centrale. Il est également possible d'utiliser des moyens d'isolation entre chaque connexion partant d'une cellule ou d'un module jusqu'à un bus de données communiquant avec l'unité centrale. On utilise généralement des opto-coupleurs, ou encore des isolateurs galvaniques magnétiques, pour obtenir une isolation électrique.

On peut noter que beaucoup de composants sont utilisés, notamment deux moyens d'isolation par cellule ou par module. L'augmentation du nombre de composants rend plus complexe la réalisation du système, et elle augmente le coût des systèmes de gestion de batterie.

Le document WO2012/171919 décrit un dispositif de gestion d'une batterie comprenant plusieurs cellules connectées en série. Le système comprend notamment plusieurs circuits de contrôle, chacun connecté électriquement en parallèle d'une cellule de la batterie et apte à émettre un signal représentatif de paramètres physiques de la cellule de batterie avec laquelle le circuit de contrôle est connecté en parallèle. Le système comprend en outre une unité de commande apte à contrôler l'état de la batterie en fonction des signaux représentatifs des paramètres physiques de chacune des cellules.

Au vu de ce qui précède, le but de l'invention est de permettre d'obtenir un système de gestion de batterie plus simple, qui utilise moins de composants, et dont le coût est réduit.

L'invention a donc pour objet un système de gestion d'une batterie comprenant une pluralité de cellules de batterie connectées en série, ce système comprenant :
- une pluralité de circuits de contrôle chacun connecté électriquement en parallèle d'une cellule de la batterie et au moins une connexion électrique entre un premier circuit de contrôle d'une première cellule et un deuxième circuit de contrôle d'une deuxième cellule, chaque circuit de contrôle étant apte à émettre un signal représentatif de paramètres physiques de la cellule de batterie avec laquelle ledit circuit de contrôle est connecté en parallèle ;
- une unité de commande apte à contrôler l'état de la batterie en fonction des signaux représentatifs des paramètres physiques de chacun desdites cellules de ladite batterie ;
- un bus de puissance reliant électriquement entre eux en série lesdites cellules de batterie ;
- chaque circuit de contrôle étant configuré pour délivrer ledit signal représentatif vers l'unité de commande au moyen du bus de puissance et uniquement après réception d'un signal de synchronisation reçu sur la connexion électrique de ce circuit de contrôle.

Selon un autre mode de réalisation, chaque circuit de contrôle :
- comporte un identifiant unique permettant de distinguer ce circuit de contrôle d'un des autres circuits de contrôle ;
- est configuré pour délivrer ledit signal représentatif vers l'unité de commande uniquement lorsque le signal de synchronisation reçu sur la connexion électrique comporte ledit identifiant unique de ce circuit de contrôle.

Selon un autre mode de réalisation :
- le premier circuit de contrôle est configuré pour :
   - délivrer le signal représentatif de paramètres physiques de la première cellule vers l'unité de commande uniquement après réception d'un premier signal de synchronisation émis par l'unité de commande, puis,
   - une fois ledit signal représentatif délivré, émettre un deuxième signal de commande sur la connexion électrique ;
- le deuxième circuit de contrôle est en outre configuré pour délivrer le signal représentatif de paramètres physiques de la deuxième cellule vers l'unité de commande uniquement après réception du deuxième signal de synchronisation au moyen de la connexion électrique.

Selon un autre mode de réalisation, le premier circuit de contrôle comprend des moyens de transmission d'un signal à travers ladite connexion électrique, le deuxième circuit de contrôle comprend des moyens de réception du signal depuis ladite connexion.

Selon un autre mode de réalisation, le signal numérique comporte au moins des informations relatives à la tension aux bornes d'au moins une cellule de batterie.

Selon un autre aspect, l'invention concerne un procédé de gestion d'une batterie comprenant une pluralité de cellules de batteries disposées en série, ce procédé comprenant :
- la fourniture d'une batterie et d'un système de gestion de la batterie comportant :
   - une pluralité de circuits de contrôle chacun connecté électriquement en parallèle d'une cellule de la batterie et au moins une connexion électrique entre un premier circuit de contrôle d'une première cellule et un deuxième circuit de contrôle d'une deuxième cellule, chaque circuit de contrôle étant apte à émettre un signal représentatif de paramètres physiques de la cellule de batterie avec lequel ledit circuit de contrôle est connecté en parallèle ;
   - un bus de puissance reliant électriquement entre eux en série lesdites cellules de batterie ;
- la transmission, par une unité de commande de la batterie, d'un premier signal de synchronisation vers le premier circuit de contrôle ;
- l'émission, par le premier circuit de contrôle, et uniquement après avoir reçu le premier signal de synchronisation, d'un signal représentatif de paramètres physiques de la première cellule de batterie à destination de ladite unité de commande et au moyen du bus de puissance ;
- la transmission d'un deuxième signal de synchronisation, par le premier circuit de contrôle vers le deuxième circuit de contrôle ;
- l'émission, par le deuxième circuit de contrôle, et uniquement après avoir reçu le deuxième signal de synchronisation, d'un signal représentatif de paramètres physiques de la deuxième cellule de batterie à destination de ladite unité de commande et au moyen du bus de puissance.

Selon un autre mode de réalisation, le signal numérique comporte au moins des informations relatives à la tension aux bornes d'au moins une cellule de batterie.

Selon un autre mode de réalisation, le procédé comporte une adaptation de la tension électrique du signal numérique vers le deuxième circuit de contrôle.

Selon un autre mode de réalisation, le procédé comporte une conversion analogique-numérique pour déduire du signal numérique le niveau de tension aux bornes d'au moins une cellule.

D'autres buts, caractéristiques et avantages de l'invention apparaîtront à la lecture de la description suivante, donnée uniquement à titre d'exemple non limitatif, et faire en référence aux dessins annexés sur lesquels :
- les figures 1 et 3 représentent schématiquement deux modes de réalisation d'un système de gestion d'une batterie électrique ;
- la figure 2 est un organigramme d'un procédé d'utilisation du système de gestion d'une batterie de la figure 1 ou de la figure 3.

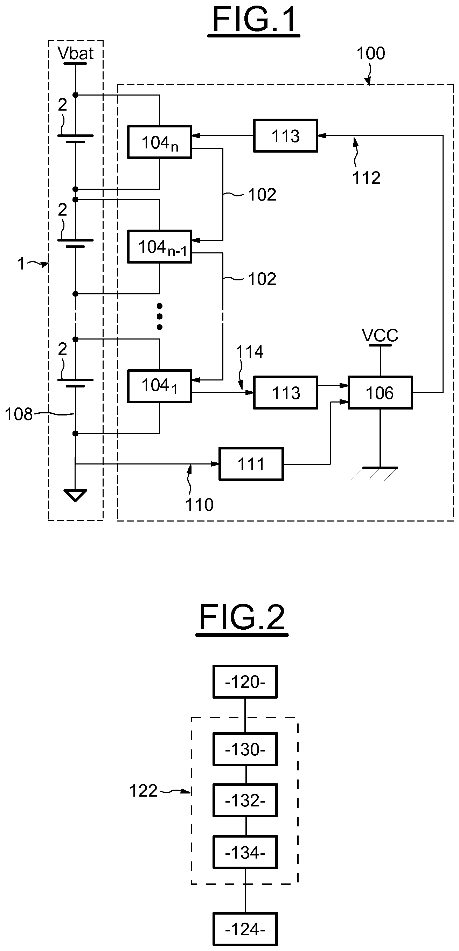

La figure 1 représente
- une batterie électrique 1, comportant n cellules de batterie 2, où n est un nombre entier strictement supérieur à 1, et
- un système de gestion de batterie 100.

La tension aux bornes de la batterie 1 est notée Vbat. Chaque cellule 2 peut comprendre une pluralité de cellules individuelles de batterie. La batterie 1 peut par exemple être destinée à alimenter en énergie électrique un moteur de véhicule automobile à traction électrique ou hybride. Ainsi, la batterie 1 peut avoir une tension Vbat de l'ordre de 400 Volts.

Le système 100 comporte ici :
- un nombre n de circuits de contrôle 104₁ à 104ₙ ;
- des connexions électriques 102 ;
- une unité de commande 106 ;
- un bus de puissance 108.

Le système 100 est connecté en de multiples points à la batterie 1. Plus précisément, chacun des circuits de contrôle 104₁ à 104ₙ est connecté en parallèle d'une des n cellules 2 et est configuré pour :
- collecter des données de paramètres physiques de la cellule 2 auquel il est connecté, puis
- émettre un signal représentatif de ces paramètres physiques, aussi nommé signal de données.

Les circuits de contrôle 104₁ à 104ₙ comprennent à cet effet des moyens de mesure de paramètres physiques des cellules 2 auxquelles ils sont connectés, des moyens de traitement de signaux numériques en réception et en transmission, et éventuellement des moyens de conversion analogique-numérique pour obtenir des valeurs des paramètres physiques à partir de tout signal entrant dans le circuit de contrôle.

Dans cette description, on définit les paramètres physiques d'une cellule 2 comme étant des grandeurs physiques caractéristiques de l'état physique de cette cellule 2. Ces paramètres physiques comprennent par exemple la température de la cellule 2, l'impédance de la cellule 2, le courant électrique fourni par la cellule 2, la tension électrique aux bornes de la cellule 2. Les paramètres physiques d'une cellule 2 sont par exemple déterminés au moyen de grandeurs physiques mesurées aux bornes de la cellule 2 par le circuit de contrôle auquel il est connecté.

Les connexions électriques 102 permettent chacune la communication, par transmission d'un signal, entre deux des circuits 104₁ à 104ₙ immédiatement voisins l'un de l'autre. Par exemple, une connexion 102 relie électriquement le circuit 104ₙ au circuit 104ₙ₋₁. Le circuit 104ₙ₋₁ est lui-même relié électriquement au circuit 104ₙ₋₂ au moyen d'un autre exemplaire d'une connexion 102. Les circuits 104₁ à 104ₙ sont ainsi tous connectés entre eux de proche en proche. Les connexions 102 forment donc ici un bus de données permettant aux circuits 104₁ à 104ₙ d'échanger des données. Il n'est nullement nécessaire de prévoir un dispositif d'isolation au sein de chaque connexion électrique 102, puisque les deux circuits 104₁ à 104ₙ sont alimentés par des cellules 2 adjacentes, et la tension électrique à leurs bornes est en général voisine.

Les circuits 104₁ à 104ₙ sont en outre configurés pour délivrer le signal représentatif vers l'unité de commande 106, au moyen du bus 108, et uniquement après réception d'un signal de synchronisation. La nature du signal de synchronisation sera décrite plus en détail dans ce qui suit. Ici, chaque circuit 104₁ à 104ₙ comporte des interfaces de réception et d'émission d'un signal de synchronisation, ainsi qu'une interface de connexion électrique à une cellule 2.

Les circuits de contrôle sont numérotés consécutivement de 1 à n. Le n-ième circuit porte la référence numérique 104ₙ. On notera 104ᵢ un circuit désignant de façon générique l'un quelconque des circuits 104₁ à 104ₙ. Les circuits de contrôle sont ici ordonnés de n à 1. Ainsi, on dira du circuit 104ₙ₋₁ qu'il s'agit du circuit suivant le circuit 104ₙ. On nomme ici 104ₙ le circuit de contrôle associé à la cellule 2 correspondant aux potentiels électriques les plus élevés de la batterie 1 et 104₁ le circuit associé à la cellule 2 correspondant aux potentiels électriques les moins élevés de la batterie 1.

Le sens de communication de la connexion électrique 102 entre deux circuits est ici indiqué par une flèche sur la figure 1 dirigée du circuit situé vers le potentiel électrique de la batterie 1 le plus élevé vers celui qui présente un potentiel électrique moins élevé.

Le bus 108 comporte une liaison électrique de puissance qui connecte électriquement entre eux et en série les n cellules 2 qui forment la batterie 1. Ce bus 108 est en outre configuré pour permettre le transport de signaux de données au moyen de techniques de courant porteur en ligne (« power line communication » en langue anglaise). A cet effet, l'unité 106 et les circuits 104₁ à 104ₙ comportent des moyens de transmission par courant porteur de ligne. En particulier, chacun des circuits 104₁ à 104ₙ est ici apte à délivrer un signal de données sur ce bus 108, par exemple au moyen des connexions électriques reliant chaque circuit aux bornes d'une cellule 2.

L'unité de commande 106 est ici apte à superviser le fonctionnement du système 100. L'unité 106 est par exemple alimentée par un autre système d'alimentation (fournissant une tension électrique d'alimentation VCC). Cette unité 106 peut traiter les informations relatives aux niveaux de tension des batteries.

L'unité 106 est notamment configurée pour :
- délivrer un signal de synchronisation vers les circuits 104ᵢ, et
- collecter les signaux de données émis par les circuits de contrôle sur le bus 108.

A cet effet, l'unité 106 est connectée électriquement :
- au bus 108, au moyen d'une connexion 110 pouvant être munie d'un dispositif d'isolation 111 ;
- à l'interface d'entrée du circuit 104ₙ au moyen d'une connexion 112 et à l'interface de sortie du circuit 104₁ au moyen d'une connexion 114, ces connexions 112 et 114 étant ici de type filaire et pouvant être elles aussi munies chacune d'un dispositif d'isolation 113 qui est par exemple identique au dispositif 111.

La connexion 110 est apte à transmettre des informations depuis les circuits de contrôle (ici à travers le circuit de contrôle 104₁) vers l'unité de commande 106. La connexion 112 permet quant à elle également de transmettre des informations depuis l'unité de commande vers les circuits de contrôle (ici à travers le circuit de contrôle 104ₙ).

Dans ce mode de réalisation, chaque circuit 104ᵢ est en outre configuré pour
- délivrer sur le bus 108 le signal de données de la cellule 2 à laquelle il est connecté, uniquement après avoir reçu un signal de synchronisation délivré par le circuit de contrôle immédiatement précédent (ou, dans le cas du circuit 104ₙ, délivré par l'unité 106) et, ici, uniquement tant que ce circuit de contrôle n'a pas délivré de signal de synchronisation ;
- une fois le signal de données délivré, émettre un signal de synchronisation à destination du circuit 104ₙ₋₁ au moyen de la connexion 102 qui le connecte à l'interface de réception du circuit 104ₙ₋₂ (ou, dans le cas du circuit 104₁, à destination de l'unité 106). Ce signal de synchronisation émis est par exemple identique au signal reçu.

La figure 2 décrit un exemple d'utilisation du système 100 pour collecter des paramètres physiques sur les cellules 2 formant la batterie 1.

Lors d'une étape 120, l'unité 106 émet un signal de synchronisation pour déclencher sélectivement l'émission des signaux de données par chacun des circuits de contrôle. Ici, le signal de synchronisation est émis puis transmis à destination du circuit 104ₙ au moyen de la connexion 112, via le dispositif d'isolation 113. La forme du signal de synchronisation est de préférence choisie pour être transmise de façon rapide d'un circuit de contrôle à l'autre.

Ensuite, lors d'une étape 122, les circuits de contrôle émettent à tour de rôle les signaux de données respectifs sur le bus 108 au fur et à mesure de la progression du signal de synchronisation d'un circuit de contrôle à l'autre. Le détail de cette étape 122 est expliqué plus en détail dans ce qui suit.

Par exemple, lors d'une opération 130, le signal de synchronisation est reçu par le circuit 104ₙ sur son interface d'entrée.

Ensuite, lors d'une opération 132, le circuit 104ₙ mesure les paramètres physiques de la cellule 2 à laquelle il est connecté, puis génère un signal de données représentatif des paramètres physiques mesurés. Ce signal de données est ensuite émis sur le bus 108. Ici, ce signal de données est transmis en modulant la tension de la cellule 2 à laquelle le circuit 104n est connecté.

Ensuite, lors d'une opération 134, le circuit 104ₙ émet un signal de synchronisation sur son interface de sortie, à destination du circuit 104ᵢ suivant. Ici, le signal de synchronisation n'est émis qu'à l'issue d'un délai prédéterminé après que le signal de données a terminé d'être émis sur le bus 108.

Les opérations 130 à 134 sont ensuite répétées de proche en proche pour chacun des circuits 104ᵢ suivants. Pour le circuit 104₁, le signal de synchronisation émis lors de l'opération 134 est émis vers l'unité 106 au moyen de la connexion 114, via le dispositif d'isolation 113.

Ainsi, chaque circuit 104ᵢ ne peut émettre les signaux de données de sa cellule 2 respective que pendant une fenêtre temporelle délimitée par l'émission et la réception du signal de commande. Ces signaux de données ne peuvent pas être émis tant que le signal de synchronisation n'a pas été reçu. Ils ne peuvent pas non plus l'être après que ce circuit de contrôle a émis à son tour le signal de synchronisation à destination du circuit de contrôle suivant. Le signal de synchronisation peut ainsi être assimilé à un jeton de synchronisation qui est détenu tour à tour par chacun des circuits 104ᵢ, chacun d'entre eux ne pouvant émettre un signal de données que lorsqu'il est en possession de ce jeton de synchronisation. Deux circuits 104ᵢ distincts ne peuvent pas détenir ce jeton de synchronisation simultanément.

Pendant l'étape 122, l'unité 106 collecte les signaux de données qui sont émis à tour de rôle sur le bus 108 par chaque circuit 104ᵢ. Ces signaux sont ici collectés au moyen de la connexion 110. Plus exactement, cette collecte comporte en outre la mesure de la différence de potentiel entre Vbat et la masse du circuit, au moyen d'une connexion non représentée sur la figure 1.

Enfin, lors d'une étape 124, l'unité 106 reçoit le signal de synchronisation émis par le circuit 104₁ et arrête de collecter les données sur le bus 108. A l'issue de l'étape 134, l'unité 106 a reçu les signaux de données envoyés par chaque circuit 104ᵢ, et dispose ainsi d'informations sur l'état physique des cellules 2 formant la batterie 1.

L'utilisation du bus de puissance 108 pour acheminer les signaux représentatifs de paramètres physiques vers l'unité 106 permet de faire transiter les données avec une vitesse accrue par rapport à l'utilisation des seules connexions 102. Cela accroît également la redondance des moyens de communication, car les données émises par les circuits 104ᵢ (et notamment des données urgentes relatives à la sécurité, tel qu'un signal d'alerte indiquant un échauffement anormal d'une des cellules 2) peuvent être transmises à destination de l'unité 106 même lorsque les connexions 102 sont inopérantes ou détruites.

De plus, en utilisant un signal de synchronisation sur les connexions 102 pour contrôler temporellement l'émission des signaux de données par les circuits 104ᵢ, on limite le risque de collision de données sur le bus 108, sans qu'il ne soit nécessaire d'utiliser un encodage particulier des signaux de données (tel que le code de Kasami), ce qui engendrerait un surcoût du système 100. Ainsi, la fiabilité des communications entre les circuits 104ᵢ et l'unité 106 est améliorée à moindre coût. Par collision de données, on désigne le cas où deux circuits 104ᵢ émettent chacun des données simultanément sur le même bus 108 de données, rendant alors ces données illisibles par l'unité 106.

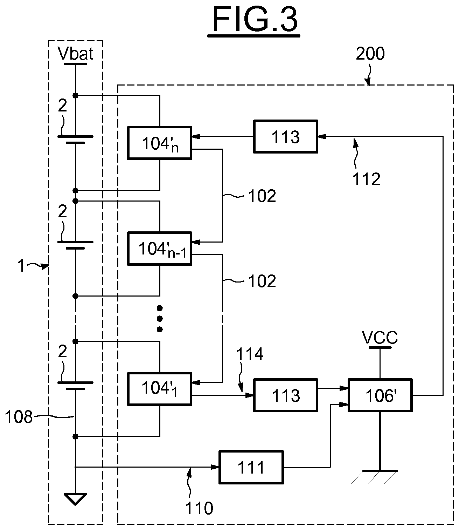

La figure 3 représente un système 200 de gestion de la batterie 1, analogue au système 100, sauf que le signal de synchronisation joue un rôle différent. Dans ce mode de réalisation, le système 200 a pour fonction de collecter des informations relatives à une seule cellule 2, dit cellule cible.

Ce système 200 est par exemple identique au système 100, sauf que :
- les circuits 104₁ à 104ₙ sont remplacés respectivement par des circuits 104'₁ à 104'ₙ qui leur sont identiques, sauf qu'ils comportent chacun un identifiant unique et sont configurés pour n'émettre le signal de données que lorsque le signal de synchronisation reçu comporte l'identifiant unique de ce circuit ;
- l'unité 106 est remplacée par une unité 106' qui lui est identique sauf qu'elle est apte à émettre un signal de synchronisation comportant l'identifiant du circuit 104'ᵢ qui est connecté à la cellule cible.

L'identification de chacun des circuits 104'ᵢ est par exemple réalisée au moyen d'un dispositif d'identification comportant par exemple le circuit d'identification tel que décrit dans la demande de brevet FR2986392 en référence aux figures 2 à 5 de cette demande. Ce circuit d'identification comporte par exemple une étiquette RFID (« Radio Frequency Identification Device » en langue anglaise) dépourvue de son antenne radio.

L'utilisation de ce système 200 comporte par exemple les étapes 130, 132 et 134, sauf que, pour chaque circuit 104'ᵢ :
- l'opération 132 n'est exécutée par le circuit 104'ᵢ que lorsque le signal de synchronisation reçu lors de l'opération 130 comporte l'identifiant unique de ce circuit 104'ᵢ ; dans le cas contraire, l'opération 134 est directement réalisée ;
- le signal de synchronisation émis lors de l'opération 134 est identique à celui reçu lors de l'opération 130.

De nombreux autres modes de réalisation sont possibles.

En variante, les circuits 104₁ à 104ₙ sont également aptes à transmettre un indicateur d'état des cellules 2 auxquelles ils sont respectivement connectés, cet indicateur d'état étant déterminé à partir de ces grandeurs physiques. Cet indicateur d'état est par exemple un alarme indiquant un dépassement d'un seuil prédéfini pour une ou plusieurs de ces grandeurs physiques.

Le sens de communication de la connexion 102 entre deux circuits peut être différent, par exemple être dirigé depuis le circuit qui présente le potentiel électrique le moins élevé vers celui qui présente le potentiel le plus élevé.

Les fonctionnalités des systèmes 100 et 200 peuvent être combinées au sein d'un même système. Les circuits de contrôle et l'unité de commande sont alors configurés en conséquence.

En variante, le système 200 peut collecter les données physiques de plus d'une cellule 2. Dans ce cas, le signal de synchronisation comporte les identifiants uniques de chacun des circuits 104'ᵢ associés aux cellules cibles dont on souhaite connaître les paramètres physiques. Pour limiter le risque de collision de données sur le bus 108, le signal de synchronisation comporte des informations de synchronisation, par exemple imposant à chaque circuit 104'ᵢ un délai d'attente prédéfini entre la réception du signal de synchronisation et le moment où le signal de donnée peut être émis par ce circuit 104'ᵢ. L'unité 106' et les circuits 104'₁ à 104'ₙ sont alors modifiés en conséquence pour traiter ce signal de synchronisation.

En variante, deux signaux de synchronisation peuvent être émis successivement par l'unité 106', destinés à des circuits 104'ᵢ différents, et comportant chacun un identifiant du circuit 104'ᵢ auquel il est destiné. Les circuits 104'ᵢ sont alors modifiés en conséquence, pour délivrer chacun sur le bus 108 un signal de données modulé à une fréquence différente. Autrement dit, les signaux de données émis par chacun de ces circuits circuit 104'ᵢ transitent sur le bus 108 par courant porteur de ligne à des fréquences différentes. Ces signaux de données peuvent ainsi être transmis simultanément sur le bus 108. L'unité 106' est alors configurée pour collecter et traiter ces signaux de données.

En variante, l'unité 106 est également apte à fournir des consignes d'équilibrage des cellules 2 aux circuits de contrôle 104ᵢ, en utilisant les connexions électriques 110 et 112 notamment. Ainsi, il n'est pas nécessaire d'utiliser une connexion électrique supplémentaire entre les moyens de mesure de tension de chaque cellule et une unité de commande, et il n'est pas non plus nécessaire d'utiliser un grand nombre de dispositifs d'isolation. Seules deux connexions munies des dispositifs d'isolation 111 et 113 sont nécessaires.

L'invention est particulièrement utile pour les véhicules automobiles.

## Revendications

1. Système de gestion d'une batterie (1) comprenant une pluralité de cellules de batterie (2) connectées en série, ainsi que :
• une pluralité de circuits de contrôle chacun connecté électriquement en parallèle d'une cellule de la batterie, chaque circuit de contrôle étant apte à émettre un signal représentatif de paramètres physiques de la cellule de batterie avec laquelle ledit circuit de contrôle est connecté en parallèle ;
• une unité de commande (106) apte à contrôler l'état de la batterie en fonction des signaux représentatifs des paramètres physiques de chacune desdites cellules de ladite batterie ;
• un bus de puissance (108) reliant électriquement entre eux en série lesdites cellules de batterie ;
chaque circuit de contrôle étant configuré pour délivrer ledit signal représentatif vers l'unité de commande au moyen du bus de puissance ;
**caractérisé en ce que** :
- le système comprend au moins une connexion électrique (102) entre un premier circuit de contrôle (104ₙ) d'une première cellule et un deuxième circuit de contrôle (104ₙ₋₁) d'une deuxième cellule ;
- chaque circuit de contrôle est en outre configuré pour délivrer ledit signal représentatif vers l'unité de commande uniquement après réception d'un signal de synchronisation reçu sur la connexion électrique de ce circuit de contrôle.

2. Système selon la revendication 1, dans lequel chaque circuit de contrôle :
- comporte un identifiant unique permettant de distinguer ce circuit de contrôle d'un des autres circuits de contrôle ;
- est configuré pour délivrer ledit signal représentatif vers l'unité de commande (106) uniquement lorsque le signal de synchronisation reçu sur la connexion électrique comporte ledit identifiant unique de ce circuit de contrôle.

3. Système selon la revendication 1 ou 2, dans lequel :
- le premier circuit de contrôle est configuré pour :
• délivrer le signal représentatif de paramètres physiques de la première cellule vers l'unité de commande uniquement après réception d'un premier signal de synchronisation émis par l'unité de commande, puis,
• une fois ledit signal représentatif délivré, émettre un deuxième signal de commande sur la connexion électrique ;
- le deuxième circuit de contrôle est en outre configuré pour délivrer le signal représentatif de paramètres physiques de la deuxième cellule vers l'unité de commande uniquement après réception du deuxième signal de synchronisation au moyen de la connexion électrique (102).

4. Système selon l'une quelconque des revendications précédentes, dans lequel le premier circuit de contrôle comprend des moyens de transmission d'un signal à travers ladite connexion électrique, le deuxième circuit de contrôle comprend des moyens de réception du signal depuis ladite connexion.

5. Système selon l'une quelconque des revendications précédentes, dans lequel ledit signal représentatif de paramètres physiques est un signal numérique comportant au moins des informations relatives à la tension aux bornes d'au moins une cellule de batterie (2).

6. Procédé de gestion d'une batterie (1) comprenant une pluralité de cellules de batteries (2) disposées en série, **caractérisé en ce qu'**il comprend :
- la fourniture d'une batterie et d'un système de gestion de la batterie comportant :
• une pluralité de circuits de contrôle chacun connecté électriquement en parallèle d'une cellule de la batterie et au moins une connexion électrique (102) entre un premier circuit de contrôle (104ₙ) d'une première cellule et un deuxième circuit de contrôle (104ₙ₋₁) d'une deuxième cellule, chaque circuit de contrôle étant apte à émettre un signal représentatif de paramètres physiques de la cellule de batterie avec lequel ledit circuit de contrôle est connecté en parallèle ;
• un bus de puissance (108) reliant électriquement entre eux en série lesdites cellules de batterie ;
- la transmission (120), par une unité de commande de la batterie, d'un premier signal de synchronisation vers le premier circuit de contrôle ;
- l'émission (132), par le premier circuit de contrôle, et uniquement après avoir reçu le premier signal de synchronisation, d'un signal représentatif de paramètres physiques de la première cellule de batterie à destination de ladite unité de commande et au moyen du bus de puissance ;
- la transmission (134) d'un deuxième signal de synchronisation, par le premier circuit de contrôle vers le deuxième circuit de contrôle ;
- l'émission, par le deuxième circuit de contrôle, et uniquement après avoir reçu le deuxième signal de synchronisation, d'un signal représentatif de paramètres physiques de la deuxième cellule de batterie à destination de ladite unité de commande et au moyen du bus de puissance.

7. Procédé selon la revendication 6, dans lequel ledit signal représentatif de paramètres physiques de la première cellule est un signal numérique comportant au moins des informations relatives à la tension aux bornes d'au moins une cellule de batterie.

8. Procédé selon la revendication 7, comprenant une adaptation de la tension électrique du signal numérique vers le deuxième circuit de contrôle.

9. Procédé selon l'une quelconque des revendications 7 ou 8, comprenant une conversion analogique-numérique pour déduire du signal numérique le niveau de tension aux bornes d'au moins une cellule.

## Patentansprüche

1. System zur Verwaltung einer Batterie (1), die eine Vielzahl von in Reihe geschalteten Batteriezellen (2) sowie
• eine Vielzahl von Überwachungskreisen, die je mit einer Zelle der Batterie elektrisch parallelgeschaltet sind, wobei jeder Überwachungskreis ein für physikalische Parameter der Batteriezelle repräsentatives Signal senden kann, mit der der Überwachungskreis parallelgeschaltet ist;
• eine Steuereinheit (106), die den Zustand der Batterie abhängig von den für physikalische Parameter jeder der Zellen der Batterie repräsentativen Signalen überwachen kann;
• einen Leistungsbus (108) enthält, der die Batteriezellen elektrisch in Reihe schaltet; wobei jeder Überwachungskreis konfiguriert ist, das repräsentative Signal mittels des Leistungsbusses an die Steuereinheit zu liefern;
**dadurch gekennzeichnet, dass**:
- das System mindestens eine elektrische Verbindung (102) zwischen einem ersten Überwachungskreis (104ₙ) einer ersten Zelle und einem zweiten Überwachungskreis (104ₙ₋₁) einer zweiten Zelle enthält;
- jeder Überwachungskreis außerdem konfiguriert ist, das repräsentative Signal nur nach Empfang eines Synchronisationssignals an die Steuereinheit zu liefern, das auf der elektrischen Verbindung dieses Überwachungskreises empfangen wird.

2. System nach Anspruch 1, wobei jeder Überwachungskreis:
- eine einzige Kennung aufweist, die es ermöglicht, diesen Überwachungskreis von einem der anderen Überwachungskreise zu unterscheiden;
- konfiguriert ist, das repräsentative Signal dann an die Steuereinheit (106) zu liefern, nur wenn das auf der elektrischen Verbindung empfangene Synchronisationssignal die einzige Kennung dieses Überwachungskreises aufweist.

3. System nach Anspruch 1 oder 2, wobei:
- der erste Überwachungskreis konfiguriert ist:
• das für physikalische Parameter der ersten Zelle repräsentative Signal nur nach Empfang eines ersten von der Steuereinheit gesendeten Synchronisationssignals an die Steuereinheit zu liefern, dann
• wenn das repräsentative Signale geliefert wurde, ein zweites Steuersignal auf der elektrischen Verbindung zu senden;
- der zweite Überwachungskreis außerdem konfiguriert ist, das für physikalische Parameter der zweiten Zelle repräsentative Signal nur nach Empfang des zweiten Synchronisationssignals mittels der elektrischen Verbindung (102) an die Steuereinheit zu liefern.

4. System nach einem der vorhergehenden Ansprüche, wobei der erste Überwachungskreis Einrichtungen zur Übertragung eines Signals über die elektrische Verbindung enthält, der zweite Überwachungskreis Einrichtungen zum Empfang des Signals von der Verbindung enthält.

5. System nach einem der vorhergehenden Ansprüche, wobei das für physikalische Parameter repräsentative Signal ein digitales Signal ist, das mindestens Informationen bezüglich der Spannung an den Klemmen mindestens einer Batteriezelle (2) aufweist.

6. Verfahren zur Verwaltung einer Batterie (1), die eine Vielzahl von in Reihe geschalteten Batteriezellen (2) enthält, **dadurch gekennzeichnet, dass** es enthält:
- die Bereitstellung einer Batterie und eines Verwaltungssystems der Batterie, das aufweist:
• eine Vielzahl von Überwachungskreisen, die je mit einer Zelle der Batterie elektrisch parallelgeschaltet sind, und mindestens eine elektrische Verbindung (102) zwischen einem ersten Überwachungskreis (104ₙ) einer ersten Zelle und einem zweiten Überwachungskreis (104ₙ₋₁) einer zweiten Zelle, wobei jeder Überwachungskreis in der Lage ist, ein für physikalische Parameter der Batteriezelle repräsentatives Signal zu senden, mit der der Überwachungskreis parallelgeschaltet ist;
• einen Leistungsbus (108), der die Batteriezellen elektrisch in Reihe schaltet;
- die Übertragung (120), durch eine Steuereinheit der Batterie, eines ersten Synchronisationssignals an den ersten Überwachungskreis;
- das Senden (132), durch den ersten Überwachungskreis, und nur nach Empfang des ersten Synchronisationssignals, eines für physikalische Parameter der ersten Batteriezelle repräsentativen Signals an die Steuereinheit und mittels des Leistungsbusses;
- die Übertragung (134) eines zweiten Synchronisationssignals durch den ersten Überwachungskreis an den zweiten Überwachungskreis;
- das Senden, durch den zweiten Überwachungskreis, und nur nach Empfang des zweiten Synchronisationssignals, eines für physikalische Parameter der zweiten Batteriezelle repräsentativen Signals an die Steuereinheit und mittels des Leistungsbusses.

7. Verfahren nach Anspruch 6, wobei das für physikalische Parameter der ersten Zelle repräsentative Signal ein digitales Signal ist, das mindestens Informationen bezüglich der Spannung an den Klemmen mindestens einer Batteriezelle aufweist.

8. Verfahren nach Anspruch 7, das eine Anpassung der elektrischen Spannung des digitalen Signals zum zweiten Überwachungskreis enthält.

9. Verfahren nach einem der Ansprüche 7 oder 8, das eine Analog-Digital-Wandlung enthält, um vom digitalen Signal den Spannungspegel an den Klemmen mindestens einer Zelle abzuleiten.

## Claims

1. System for managing a battery (1) comprising a plurality of battery cells (2) connected in series, and:
• a plurality of control circuits, each electrically connected in parallel with a cell of a battery, each control circuit being capable of emitting a signal that is representative of physical parameters of the battery cell with which said control circuit is connected in parallel;
• a control unit (106) capable of controlling the state of the battery on the basis of the signals that are representative of the physical parameters of each of said cells of said battery;
• a power bus (108) electrically connecting said battery cells to one another in series;
each control circuit being configured to deliver said representative signal to the control unit by means of the power bus;
**characterized in that**: the system comprises at least one electrical connection (102) between a first control circuit (104ₙ) of a first cell and a second control circuit (104ₙ₋₁) of a second cell; and
- each control circuit is further configured to deliver said representative signal to the control unit only after reception of a synchronization signal received on the electrical connection of this control circuit.

2. System according to Claim 1, in which each control circuit:
- has a unique identifier allowing this control circuit to be distinguished from one of the other control circuits;
- is configured to deliver said representative signal to the control unit (106) only when the synchronization signal received on the electrical connection has said unique identifier of this control circuit.

3. System according to Claim 1 or 2, in which:
- the first control circuit is configured to:
• deliver the signal that is representative of physical parameters of the first cell to the control unit only after reception of a first synchronization signal emitted by the control unit, then,
• once said representative signal has been delivered, emit a second control signal on the electrical connection;
- the second control circuit is moreover configured to deliver the signal that is representative of physical parameters of the second cell to the control unit only after reception of the second synchronization signal by means of the electrical connection (102).

4. System according to any one of the preceding claims, in which the first control circuit comprises means for transmitting a signal through said electrical connection, the second control circuit comprises means for receiving the signal from said connection.

5. System according to any one of the preceding claims, in which said signal representative of physical parameters is a digital signal having at least information relating to the voltage across the terminals of at least one battery cell (2).

6. Method for managing a battery (1) comprising a plurality of battery cells (2) arranged in series, **characterized in that** it comprises:
- the provision of a battery and of a system for managing the battery having:
• a plurality of control circuits, each electrically connected in parallel with a cell of the battery and at least one electrical connection (102) between a first control circuit (104ₙ) of a first cell and a second control circuit (104ₙ₋₁) of a second cell, each control circuit being capable of emitting a signal that is representative of physical parameters of the battery cell with which said control circuit is connected in parallel;
• a power bus (108) electrically connecting said battery cells to one another in series;
- the transmission (120), by a control unit of the battery, of a first synchronization signal to the first control circuit;
- the emission (132), by the first control circuit, and only after having received the first synchronization signal, of a signal that is representative of physical parameters of the first battery cell to said control unit and by means of the power bus;
- the transmission (134) of a second synchronization signal, by the first control circuit, to the second control circuit;
- the emission, by the second control circuit, and only after having received the second synchronization signal, of a signal that is representative of physical parameters of the second battery cell to said control unit and by means of the power bus.

7. Method according to Claim 6, in which said signal representative of physical parameters is a digital signal having at least information relating to the voltage across the terminals of at least one battery cell.

8. Method according to Claim 7, comprising an adaptation of the electrical voltage of the digital signal to the second control circuit.

9. Method according to either one of Claims 7 and 8, comprising an analogue/digital conversion in order to deduce the voltage level across the terminals of at least one cell from the digital signal.
